# EUROPÄISCHE PATENTSCHRIFT

(11) **EP 0 420 343 B1**
(45) Veröffentlichungstag und Bekanntmachung des Hinweises auf die Patenterteilung: **04.01.1995**
(21) Anmeldenummer: 90202529.5
(22) Anmeldetag: 25.09.1990
(51) Int. Cl.: H03G 1/00, H03G 3/10

(54) **Schaltungsanordnung zur elektronischen Pegelsteuerung eines Tonsignals**
Electronic control circuit for audio-signal level
Circuit de commande électronique du niveau d'un signal audio

(30) Priorität: 28.09.1989 AT 2265/89
(43) Veröffentlichungstag der Anmeldung: 03.04.1991
(73) Patentinhaber: Philips Electronics N.V., 5621 BA Eindhoven (NL)
(72) Erfinder: Hasler, Rudolf, NL-5656 AA Eindhoven (NL)
(74) Vertreter: Faessen, Louis Marie Hubertus

(56) Entgegenhaltungen:
- US-A- 3 886 464
- US-A- 4 062 042
- ELECTRONIC DESIGN. Bd. 23, Nr. 4, 24. Mai 1975, HASBROUCK HEIGHTS, NEW JERSEY Seite 98; L. KAPLAN: 'CMOS Audio Amplifier Features +/- 15 dB Bass/Treble Control Range '

## Beschreibung

Die Erfindung betrifft eine Schaltungsanordnung zur elektronischen Pegelsteuerung eines Tonsignales mit einer in einen Tonsignalweg eingeschalteten Verstärkerschaltung, deren Verstärkungsgrad in Abhängigkeit von einer veränderbaren Steuergleichspannung steuerbar ist, und mit einer Spannungseinstellstufe zum Erzeugen der veränderbaren Steuergleichspannung, von deren Ausgang die erzeugte veränderbare Steuergleichspannung der Verstärkerschaltung zur Steuerung von deren Verstärkungsgrad zugeführt wird.

Eine solche Schaltungsanordnung ist beispielsweise aus der DE-AS 21 36 247 bekannt. Bei dieser bekannten Schaltungsanordnung weist die Verstärkerschaltung einen aus zwei bipolaren Transistoren bestehenden Differentialverstärker auf und ist die Spannungseinstellstufe durch ein an eine Gleichspannungsquelle angeschaltetes veränderbares Widerstandselement gebildet, mit dem eine Steuergleichspannung erzeugt wird, die der Basis eines dritten bipolaren Transistors der Verstärkerschaltung zugeführt wird, der eine Stromquelle für die beiden Transistoren des Differentialverstärkers bildet und der in Abhängigkeit von der seiner Basis zugeführten Steuergleichspannung den den beiden Transistoren des Differentialverstärkers von ihm zugeführten Strom und damit die Signalkopplung zwischen diesen beiden Transistoren steuert. Bei dieser bekannten Schaltungsanordnung wird der gesamte Einstellbereich des Differentialverstärkers zur Pegelsteuerung beziehungsweise Pegeleinstellung eines Tonsignales mit relativ kleinen Änderungen der Steuergleichspannung erreicht, wodurch aber eine relativ große Abhängigkeit des Einstellverhaltens des Differentialverstärkers von Toleranzen der Bauteile und Spannungswerte und von thermischen Einflüssen besteht. Weiters sind bei dieser bekannten Schaltungsanordnung zur Erzielung eines möglichst optimalen Einstellverhaltens des Differentialverstärkers relativ hohe Spannungen und relativ hohe Ströme erforderlich. Für den Fall einer Verwendung der bekannten Schaltungsanordnung für die Pegelsteuerung beziehungsweise Pegeleinstellung von Stereosignalen, wobei dann, wie aus der DE-AS 21 36 247 ersichtlich ist, in jedem der beiden Stereokanäle ein solcher Differentialverstärker vorgesehen ist, besteht weiters das Problem, daß aufgrund der vorerwähnten Toleranz- und Temperaturabhängigkeit nur sehr schwierig für beide Stereokanäle dieselbe Einstellwirkung zur Pegelsteuerung beziehungsweise Pegeleinstellung über den gesamten Einstellbereich erreicht werden kann.

Die Erfindung hat sich zur Aufgabe gestellt, die vorstehend angeführten Schwierigkeiten zu vermeiden und eine Schaltungsanordnung der eingangs angeführten Gattung so auszubilden, daß sie sowohl einen einfachen Schaltungsaufbau als auch einen relativ großen Einstellbereich aufweist und daß der gesamte mit der Verstärkerschaltung erzielte Einstellbereich mit einer relativ großen Änderung der Steuergleichspannung erreicht wird und ein möglichst gutes Einstellverhalten der Verstärkerschaltung bei relativ kleinen Versorgungsspannungen und kleinen Strömen erhalten wird. Hiefür ist die Erfindung dadurch gekennzeichnet, daß die Verstärkerschaltung durch einen CMOS-Inverter mit einem Signaleingang, einem Signalausgang und einem Versorgungsspannungsanschluß gebildet ist, dessen Signaleingang ein Serienvorwiderstand vorgeschaltet ist, über den das in seinem Pegel zu steuernde Tonsignal dem Signaleingang des CMOS-Inverters zugeführt wird, und von dessen Signalausgang das in seinem Pegel gesteuerte Tonsignal abgenommen wird und dessen Versorgungsspannungsanschluß die mit der Spannungseinstellstufe erzeugte veränderbare Steuergleichspannung als Versorgungsspannung für den CMOS-Inverter zugeführt wird, wobei in Abhängigkeit von der dem Versorgungsspannungsanschluß zugeführten Steuergleichspannung der CMOS-Inverter in seinem Anlaufbereich unterhalb der Kniespannung betrieben wird, in dem mit abnehmender Steuergleichspannung der Verstärkungsgrad des CMOS-Inverters abnimmt und zusätzlich der dynamische Ausgangswiderstand des CMOS-Inverters zunimmt.

Mit der erfindungsgemäßen Schaltungsanordnung ist erreicht, daß in Abhängigkeit von der veränderbaren Steuergleichspannung, die dem als Verstärkerschaltung vorgesehenen CMOS-Inverter als Versorgungsspannung zugeführt wird, sowohl der Verstärkungsgrad des CMOS-Inverters als auch der dynamische Ausgangswiderstand des CMOS-Inverters veränderbar ist, und zwar in der Weise, daß mit abnehmender Steuergleichspannung der Verstärkungsgrad abnimmt und der dynamische Ausgangswiderstand zunimmt. Der dynamische Ausgangswiderstand des CMOS-Inverters bildet mit einer an den Ausgang des CMOS-Inverters angeschlossenen Lastimpedanz einen Spannungsteiler für das in seinem Pegel gesteuerte Tonsignal, der bei steigendem dynamischen Ausgangswiderstand aufgrund des sich ändernden Spannungsteilerverhältnisses ein in seinem Pegel abnehmendes Tonsignal liefert. Weiters liefert aufgrund des bei abnehmender Steuergleichspannung abnehmenden Verstärkungsgrades der CMOS-Inverter bei abnehmender Steuergleichspannung ebenfalls ein in seinem Pegel abnehmendes Tonsignal. Bei der erfindungsgemäßen Schaltungsanordnung sind somit zur Steuerung beziehungsweise Einstellung des Pegels eines Tonsignales zwei einander sich gleichsinnig überlagernde Effekte maßgeblich, nämlich die zur Veränderung der dem CMOS-Inverter zugeführten Steuergleichspannung direkt proportionale Veränderung des Verstärkungsgrades des CMOS-Inverters und die zur Veränderung der dem CMOS-Inverter zugeführten Steuergleichspannung umgekehrt proportionale Veränderung des dynamischen Ausgangswiderstandes des CMOS-Inverters. Auf diese Weise wird mit besonders einfachen Mitteln, nämlich mit nur einem einzigen CMOS-Inverter, der in seinem Anlaufbereich unterhalb der Kniespannung betrieben wird, ein relativ großer Einstellbereich bei der elektronischen Steuerung beziehungsweise Einstellung des Pegels eines Tonsignales erreicht. Aufgrund der Verwendung eines CMOS-Inverters kann wegen dessen Eigenschaften in seinem Anlaufbereich zur Pegelsteuerung eines Tonsignales die Steuergleichspannung in einem relativ großen Bereich verändert werden, was hinsichtlich eines geringen Einflusses von Toleranzen und thermischen Einflüssen auf das Einstellverhalten günstig ist. Durch den Betrieb des CMOS-Inverters in seinem Anlaufbereich unterhalb der Kniespannung ist weiters vorteilhafterweise erreicht, daß mit niedrigen Steuergleichspannungen, die dem CMOS-Inverter als Versorgungsspannung zugeführt werden, das Auslangen gefunden wird und daß nur sehr kleine Ströme auftreten. Ein weiterer Vorteil der Verwendung eines CMOS-Inverters, der in seinem Anlaufbereich unterhalb der Kniespannung betrieben wird, besteht darin, daß eine lineare Veränderung der Steuergleichspannung eine logarithmische Veränderung des Ausgangssignals des CMOS-Inverters, also des in seinem Pegel gesteuerten Tonsignales, zur Folge hat, wie dies für eine einwandfreie, dem logarithmischen Hörempfinden des Ohres angepaßte Lautstärkensteuerung erwünscht ist. Weiters wird für den Fall einer Verwendung der erfindungsgemäßen Schaltungsanordnung zur elektronischen Pegelsteuerung beziehungsweise Pegeleinstellung von Stereosignalen, wobei dann in jedem der beiden Stereokanäle ein solcher CMOS-Inverter vorgesehen ist, aufgrund der geringen Toleranz- und Temperaturabhängigkeit von solchen CMOS-Invertern für beide Stereokanäle dasselbe Einstellverhalten über den gesamten Einstellbereich, also ein guter Gleichlauf, erhalten.

Hinsichtlich der Erzielung eines möglichst großen Einstellbereiches hat sich als besonders vorteilhaft erwiesen, wenn an die Verbindung zwischen dem Serienvorwiderstand und dem Signaleingang des CMOS-Inverters ein im wesentlichen durch zwei in Serie geschaltete Dioden gebildeter, in seinem Widerstandswert steuerbarer dynamischer Widerstand angeschaltet ist, wobei die Verbindung zwischen dem Serienvorwiderstand und dem Signaleingang des CMOS-Inverters mit der Verbindung zwischen den beiden Dioden des dynamischen Widerstandes verbunden ist, der mit dem Serienvorwiderstand einen Spannungsteiler für das dem CMOS-Inverter zugeführte, in seinem Pegel zu steuernde Tonsignal bildet, und die mit der Spannungseinstellstufe erzeugte veränderbare Steuergleichspannung dem durch die beiden Dioden gebildeten dynamischen Widerstand an einem Anschluß einer Diode zur Steuerung des Widerstandswertes desselben zugeführt wird, wobei mit abnehmender Steuergleichspannung der Widerstandswert des dynamischen Widerstandes abnimmt. Auf diese Weise ist erreicht, daß mit abnehmender Steuergleichspannung das Spannungsteilerverhältnis zwischen dem Serienvorwiderstand und dem durch die beiden Dioden gebildeten, in seinem Widerstandswert steuerbaren dynamischen Widerstand sich so verändert, daß ein Absenken des Pegels des dem Signaleingang des CMOS-Inverters zugeführten Tonsignales erreicht wird. Somit wird mit ebenfalls sehr einfachen weiteren Mitteln, nämlich im wesentlichen mit zwei Dioden, ein zusätzlicher Effekt zum Steuern des Pegels eines Tonsignales erhalten, der sich gleichsinnig den beiden vorstehend genannten Effekten, nämlich der Abnahme der Verstärkung und der Zunahme des dynamischen Ausgangswiderstandes des CMOS-Inverters bei abnehmender Steuergleichspannung, überlagert, wodurch der Einstellbereich bei der elektronischen Steuerung beziehungsweise Einstellung des Pegels eines Tonsignales weiter vergrößert wird. Das Vorsehen der beiden Dioden bietet zusätzlich den Vorteil, daß eine Übersteuerung des CMOS-Inverters bei abnehmender Steuergleichspannung, die als Versorgungsspannung für den CMOS-Inverter dessen Versorgungsspannungsanschluß zugeführt wird, verhindert ist. Durch das Vorsehen von zwei solchen in Serie geschalteten Dioden ist vorteilhafterweise weiters erreicht, daß der dynamische Widerstand unabhängig von der Signalamplitude des an den Dioden anliegenden Tonsignales im wesentlichen konstant bleibt.

Weiters hat sich als vorteilhaft erwiesen, wenn die Verbindung zwischen dem Serienvorwiderstand und dem Signaleingang des CMOS-Inverters und die Verbindung zwischen den beiden Dioden des dynamischen Widerstandes über einen Kondensator verbunden sind, der mit dem Serienvorwiderstand einen Hochpaß bildet, über den Mittelton- und Hochton-Signalanteile eines in seinem Pegel zu steuernden Tonsignales dem dynamischen Widerstand zur Bedämpfung dieser Signalanteile zugeführt werden. Auf diese Weise ist erreicht, daß bei geringen Lautstärken - die durch Herabregeln der Steuergleichspannung auf niedrige Spannungswerte eingestellt werden, wobei dann der dynamische Widerstand einen kleinen Widerstandswert aufweist - Mittelton- und Hochton-Signalanteile in Relation zu Tiefton-Signalanteilen abgesenkt werden, was einer relativen Anhebung der Tiefton-Signalanteile entspricht, wodurch eine hinsichtlich von Tiefton-Signalanteilen gute physiologische Lautstärkensteuerung erzielt wird.

Als besonders vorteilhaft hat sich in diesem Zusammenhang erwiesen, wenn mit dem vom Signaleingang des CMOS-Inverters abgewandten Anschluß des Serienvorwiderstandes ein Anschluß eines weiteren Hochpasses verbunden ist, dessen anderer Anschluß mit mindestens einer Diode des dynamischen Widerstandes an dem von der Verbindung zwischen den beiden Dioden abgewandten Anschluß der Diode verbunden ist, wobei unter teilweiser Überbrückung des Serienvorwiderstandes über den weiteren Hochpaß und die mit diesem verbundene Diode des dynamischen Widerstandes sowie den zwischen der Verbindung zwischen den beiden Dioden und der Verbindung zwischen dem Serienvorwiderstand und dem Signaleingang des CMOS-Inverters vorgesehenen Kondensator Hochton-Signalanteile eines in seinem Pegel zu steuernden Tonsignales zusätzlich dem Signaleingang des CMOS-Inverters zur Anhebung dieser Hochton-Signalanteile zugeführt werden. Auf diese Weise ist erreicht, daß bei geringen Lautstärken - die durch Herabregeln der Steuergleichspannung auf niedrige Spannungswerte eingestellt werden, wobei dann der dynamische Widerstand 34 einen kleinen Widerstandswert aufweist - zusätzlich zu der vorstehend erläuterten Anhebung der Tiefton-Signalanteile auch eine Anhebung der Hochton-Signalanteile erfolgt, wodurch eine besonders gute physiologische Lautstärkensteuerung erzielt wird.

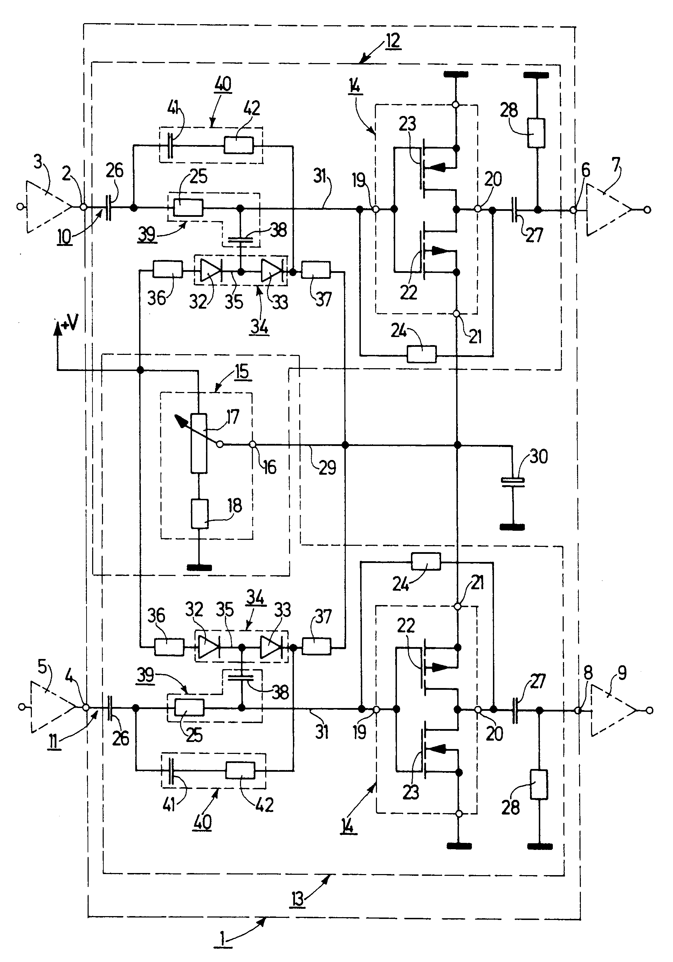

Die Erfindung wird im folgenden anhand eines in der Zeichnung dargestellten Ausführungsbeispieles, auf das sie jedoch nicht beschränkt sein soll, näher beschrieben. Die einzige Figur zeigt eine Schaltungsanordnung zur elektronischen Pegelsteuerung eines Stereo-Tonsignales, wobei in jedem der beiden Stereokanäle eine erfindungsgemäße Schaltungsanordnung zur elektronischen Pegelsteuerung eines Tonsignales vorgesehen ist.

Die Figur zeigt eine Schaltungsanordnung 1 zur elektronischen Pegelsteuerung beziehungsweise Pegeleinstellung eines Stereo-Tonsignales, die einen ersten Eingangsanschluß 2, dem beispielsweise von einem schematisch angedeuteten ersten Vorverstärker 3 das in seinem Pegel zu steuernde Tonsignal des linken Kanals zugeführt wird, und die einen zweiten Eingangsanschluß 4 aufweist, dem beispielsweise von einem schematisch angedeuteten zweiten Vorverstärker 5 das in seinem Pegel zu steuernde Tonsignal des rechten Kanals zugeführt wird. Die Schaltungsanordnung 1 weist ferner einen ersten Ausgangsanschluß 6, von dem das in seinem Pegel gesteuerte Tonsignal des linken Kanals beispielsweise einem schematisch angedeuteten ersten Endstufenverstärker 7 zugeführt wird, und einen zweiten Ausgangsanschluß 8 auf, von dem das in seinem Pegel gesteuerte Tonsignal des rechten Kanals beispielsweise einem schematisch angedeuteten zweiten Endstufenverstärker 9 zugeführt wird. In jedem der beiden Stereokanäle 10 und 11 ist eine Schaltungsanordnung 12 bzw. 13 zur elektronischen Pegelsteuerung beziehungsweise Pegeleinstellung des betreffenden Tonsignales vorgesehen. Diese beiden Schaltungsanordnungen 12 und 13 weisen eine vollkommen gleiche Schaltungsausbildung auf, weshalb die Bauteile derselben der Einfachheit halber mit denselben Bezugszeichen bezeichnet sind.

Die Schaltungsanordnung 12 bzw. 13 zur elektronischen Pegelsteuerung eines Tonsignales weist eine in den Tonsignalweg, also in den Stereokanal 10 bzw. 11, eingeschaltete Verstärkerschaltung 14 auf, deren Verstärkungsgrad in Abhängigkeit von einer veränderbaren Steuergleichspannung steuerbar ist. Zum Erzeugen der veränderbaren Steuergleichspannung ist eine Spannungseinstellstufe 15 vorgesehen, von deren Ausgang 16 die erzeugte veränderbare Steuergleichspannung der Verstärkerschaltung 14 zur Steuerung von deren Verstärkungsgrad zugeführt wird.

Die Spannungseinstellstufe 15 weist ein Potentiometer 17, das einerseits an einen Versorgungsspannungsanschluß +V und andererseits über einen Fußpunkt-Widerstand 18 an ein Bezugspotential, nämlich Massepotential, angeschaltet ist. Der Schleifer des Potentiometers 17 ist mit dem Ausgang 16 der Spannungseinstellstufe 15 verbunden. Durch das Vorsehen des Fußpunkt-Widerstandes 18 ist erreicht, daß die mit der Spannungseinstellstufe 15 erzeugte, am Ausgang 16 auftretende Steuergleichspannung nicht unter einen bestimmten Mindestspannungswert sinken kann. Die Spannungseinstellstufe muß nicht mit einem Potentiometer ausgebildet werden, wie dies bei der dargestellten Schaltungsanordnung der Fall ist. Eine solche Spannungseinstellstufe kann beispielsweise auch einen als Integrator mit praktisch unendlich großer Zeitkonstante ausgebildeten Gleichspannungsverstärker aufweisen, dessen Eingangsspannung mit Hilfe von beispielsweise zwei Tipptasten zwischen einem vorgegebenen Gleichspannungspotential und einem Bezugspotential einstellbar ist und der an seinem Ausgang eine der eingestellten Eingangsspannung entsprechende Ausgangsspannung als Steuergleichspannung abgibt. Eine solche Spannungseinstellstufe kann aber auch eine Digital/Analog-Wandlerschaltung aufweisen, die in Abhängigkeit von einem ihr mittels einer Fernbedienungseinrichtung zugeführten digitalen Signales einen Gleichspannungswert erzeugt, den sie als Steuergleichspannung abgibt.

Die Verstärkerschaltung 14 ist nunmehr in besonders einfacher und vorteilhafter Weise durch einen in der Figur schematisiert dargestellten CMOS-Inverter gebildet, der einen Signaleingang 19, einen Signalausgang 20 und einen Versorgungsspannungsanschluß 21 aufweist. Der CMOS-Inverter 14 enthält in bekannter Weise zwei in der Figur dargestellte komplementäre MOS-Feldeffekttransistoren 22 und 23 sowie nicht dargestellte Schutz-Widerstände und Schutz-Dioden. Beispielsweise kann zur Realisierung eines solchen CMOS-Inverters ein von der Anmelderin erzeugter und unter der Typenbezeichnung PC74HCUO4 im Handel erhältlicher CMOS-Inverter-Baustein verwendet werden, der sechs solche CMOS-Inverter enthält.

Der Signalausgang 20 und der Signaleingang 19 des CMOS-Inverters 14 sind über einen Gegenkopplungswiderstand 24 miteinander verbunden, durch den der Arbeitspunkt des CMOS-Inverters 14 festgelegt ist. Dem Signaleingang 19 ist ein Serienvorwiderstand 25 vorgeschaltet, der gemeinsam mit dem Gegenkopplungswiderstand 24 die Verstärkung des CMOS-Inverters 14 bestimmt. Der Serienvorwiderstand 25 ist über einen Kondensator 26 zur Gleichstromtrennung mit dem Eingangsanschluß 2 bzw. 4 verbunden. Über den Serienvorwiderstand 25 wird das in seinem Pegel zu steuernde Tonsignal dem Signaleingang 19 des CMOS-Inverters 14 zugeführt. Von dem Signalausgang 20 des CMOS-Inverters 14 wird das in seinem Pegel gesteuerte Tonsignal abgenommen. An den Signalausgang 20 ist über einen Kondensator 27 zur Gleichstromtrennung ein Lastwiderstand 28 angeschlossen. Die am Lastwiderstand 28 abfallende Spannung wird über den Ausgangsanschluß 6 bzw. 8 dem Endstufenverstärker 7 bzw. 9 zugeführt.

Dem Versorgungsspannungsanschluß 21 des CMOS-Inverters 14 wird die mit der Spannungseinstellstufe 15 erzeugte, an deren Ausgang 16 auftretende veränderbare Steuergleichspannung als Versorgungsspannung für den CMOS-Inverter 14 über eine elektrisch leitende Verbindung 29 zugeführt. In Abhängigkeit von der dem Versorgungsspannungsanschluß 21 zugeführten Steuergleichspannung wird der CMOS-Inverter 14 in seinem Anlaufbereich unterhalb der Kniespannung betrieben, in dem mit abnehmender Steuergleichspannung der Verstärkungsgrad des CMOS-Inverters 14 abnimmt und zusätzlich der dynamische Ausgangswiderstand des CMOS-Inverters 14 zunimmt.

Für den vorstehend erwähnten Fall, daß die Realisierung des CMOS-Inverters 14 mit Hilfe des CMOS-Inverter-Bausteins PC74HCUO4 erfolgt, ist hinsichtlich der Wahl der Größe der Versorgungsspannung für diesen CMOS-Inverter folgendes festzuhalten. Der Baustein PC74HCUO4 ist für eine Spannungsversorgung mit einer Versorgungsspannung von üblicherweise zwischen 2 und 6 Volt vorgesehen. Bei einer solchen Spannungsversorgung wird jeder der in diesem Baustein enthaltenen CMOS-Inverter in seinem Abschnürbereich oberhalb der Kniespannung betrieben. Um einen solchen CMOS-Inverter in seinem Anlaufbereich unterhalb der Kniespannung zu betreiben, wie dies bei der vorliegenden Schaltungsanordnung der Fall sein soll, wird die zugeführte Versorgungsspannung, die durch die mit der Spannungseinstellstufe 15 erzeugte Steuergleichspannung gebildet ist, dementsprechend niedriger gewählt. In der Praxis hat sich dabei als zweckmäßig erwiesen, wenn die Steuergleichspannung auf maximal etwa 1,7 Volt eingestellt wird. Zur Pegeleinstellung eines Tonsignales wird die Steuergleichspannung zwischen diesem Wert von 1,7 Volt und einem Wert von etwa 0,8 Volt mit Hilfe des Potentiometers 17 verändert. Unterhalb von 0,8 Volt kann die Steuergleichspannung wegen des Fußpunkt-Widerstandes 18 nicht sinken. Durch das Vorsehen des Fußpunkt-Widerstandes 18 ist daher erreicht, daß dem CMOS-Inverter 14 als Versorgungsspannung eine bestimmte Mindestspannung zugeführt wird, durch die gewährleistet ist, daß der CMOS-Inverter 14 einwandfrei als Verstärker arbeitet. Würde ein Absinken der Versorgungsspannung für den CMOS-Inverter 14, also der ihm zugeführten Steuergleichspannung, unter den vorgenannten Mindestwert von etwa 0,8 Volt auftreten, dann würde der CMOS-Inverter 14 seine ordnungsgemäße Funktion überhaupt einstellen, Was aber nicht zulässig ist.

Mit der Verbindung 29 zwischen dem Ausgang 16 der Spannungseinstellstufe 15 und dem Versorgungsspannungsanschluß 21 des CMOS-Inverters 14 ist ein Kondensator 30 verbunden. Dieser Kondensator 30 ist im vorliegenden Fall, wo die Steuergleichspannung über die Verbindung 29 an die Versorgungsspannungsanschlüsse 21 von zwei CMOS-Invertern 14 in den beiden Stereokanälen 10 und 11 angelegt wird, dazu vorgesehen, eine gegenseitige Beeinflussung der beiden mit ihren Versorgungsspannunganschlüssen 21 über die Verbindung 29 miteinander verbundenen CMOS-Inverter 14 zu unterbinden.

Durch das Betreiben des als Verstärkerschaltung vorgesehenen CMOS-Inverters 14 in seinem Anlaufbereich unterhalb der Kniespannung wird bei der vorliegenden Schaltungsanordnung 12 bzw. 13 zur elektronischen Pegelsteuerung beziehungsweise Pegeleinstellung eines Tonsignales in Abhängigkeit von der veränderbaren Steuergleichspannung, die dem CMOS-Inverter 14 als Versorgungsspannung zugeführt wird, sowohl der Verstärkungsgrad des CMOS-Inverters 14 als auch der dynamische Ausgangswiderstand des CMOS-Inverters 14 verändert, und zwar in der Weise, daß mit abnehmender Steuergleichspannung der Verstärkungsgrad ebenfalls abnimmt und der dynamische Ausgangswiderstand aber zunimmt. Der dynamische Ausgangswiderstand des CMOS-Inverters 14 bildet mit dem an den Signalausgang 20 angeschlossenen Lastwiderstand 28 einen Spannungsteiler für das in seinem Pegel gesteuerte Tonsignal. Dieser Spannungsteiler liefert bei abnehmender Steuergleichspannung und folglich steigendem dynamischen Ausgangswiderstand aufgrund des sich ändernden Spannungsteilerverhältnisses ein in seinem Pegel abnehmendes Tonsignal. Weiters liefert aufgrund des bei abnehmender Steuergleichspannung abnehmenden Verstärkungsgrades der CMOS-Inverter 14 bei abnehmender Steuergleichspannung ebenfalls ein in seinem Pegel abnehmendes Tonsignal. Es sind somit zur Steuerung des Pegels eines Tonsignales zwei einander sich gleichsinnig überlagernde Effekte maßgeblich, nämlich die zur Veränderung der dem CMOS-Inverter zugeführten Steuergleichspannung direkt Proportionale Veränderung des Verstärkungsgrades des CMOS-Inverters 14 und die zur Veränderung der dem CMOS-Inverter zugeführten Steuergleichspannung umgekehrt proportionale Veränderung des dynamischen Ausgangswiderstandes des CMOS-Inverters 14. Auf diese Weise wird mit nur einem einzigen CMOS-Inverter, der in seinem Anlaufbereich unterhalb der Kniespannung betrieben wird, ein relativ großer Einstellbereich bei der elektronischen Steuerung beziehungsweise Einstellung des Pegels eines Tonsignales erreicht. Aufgrund der Eigenschaften eines CMOS-Inverters in seinem Anlaufbereich kann die Steuergleichspannung zur Pegelsteuerung eines Tonsignales in einem relativ großen Bereich verändert werden, beispielsweise bei Verwendung des CMOS-Inverter-Bausteins PC74HCUO4 in einem Bereich zwischen etwa 1,7 Volt und etwa 0,8 Volt, also in einem Bereich von etwa 0,9 Volt, was hinsichtlich eines geringen Einflusses von Toleranzen und thermischen Einflüssen auf das Einstellverhalten günstig ist. Durch den Betrieb des CMOS-Inverters in seinem Anlaufbereich unterhalb der Kniespannung ist weiters vorteilhafterweise erreicht, daß mit niedrigen Steuergleichspannungen, die dem CMOS-Inverter als Versorgungsspannung zugeführt werden, das Auslangen gefunden wird und daß nur sehr kleine Ströme auftreten. Für den Fall der Verwendung des CMOS-Inverter-Bausteins PC74HCUO4 liegt die Steuergleichspannung unter etwa 1,7 Volt und treten Ströme in der Größenordnung von nur einigen bis 100µA auf. Ein weiterer Vorteil der Verwendung eines CMOS-Inverters, der in seinem Anlaufbereich unterhalb der Kniespannung betrieben wird, besteht darin, daß eine lineare Veränderung der Steuergleichspannung eine logarithmische Veränderung des Ausgangssignales des CMOS-Inverters, also des in seinem Pegel gesteuerten Tonsignales, zur Folge hat, wie dies für eine einwandfreie, dem logarithmischen Hörempfinden des Ohres angepaßte Lautstärkensteuerung erwünscht ist. Weiters wird bei der vorliegenden Schaltungsanordnung zur Pegelsteuerung beziehungsweise Pegeleinstellung eines Stereo-Tonsignales, bei der in jedem der beiden Stereokanäle ein solcher CMOS-Inverter vorgesehen ist, aufgrund der geringen Toleranz- und Temperaturabhängigkeit von solchen CMOS-Invertern für beide Stereokanäle dasselbe Einstellverhalten über den gesamten Einstellbereich, also ein guter Gleichlauf, erhalten.

Bei der Schaltungsanordnung 12 bzw. 13 ist an die Verbindung 31 zwischen dem Serienvorwiderstand 25 und dem Signaleingang 19 des CMOS-Inverters 14 ein im wesentlichen durch zwei in Serie geschaltete Dioden 32 und 33 gebildeter, in seinem Widerstandswert steuerbarer dynamischer Widerstand 34 angeschaltet. Dabei ist die Verbindung 31 zwischen dem Serienvorwiderstand 25 und dem Signaleingang 19 des CMOS-Inverters mit der Verbindung 35 zwischen den beiden Dioden 32 und 33 des dynamischen Widerstandes 34 verbunden. Der durch die beiden Dioden 32 und 33 gebildete dynamische Widerstand 34 bildet mit dem Serienvorwiderstand 25 einen Spannungsteiler für das dem CMOS-Inverter 14 zugeführte, in seinem Pegel zu steuernde Tonsignal. Von der Diode 32 ist die Anode über einen Vorwiderstand 36 mit dem Versorgungsspannungsanschluß +V und von der anderen Diode 33 ist die Kathode über einen weiteren Vorwiderstand 37 mit dem Ausgang 16 der Spannungseinstellstufe 15 über die Verbindung 29 verbunden. Auf diese Weise wird die mit der Spannungseinstellstufe 15 erzeugte veränderbare Steuergleichspannung über den Vorwiderstand 37 dem durch die beiden Dioden 32 und 33 gebildeten dynamischen Widerstand 34 an der Kathode der Diode 33 zur Steuerung des Widerstandswertes des dynamischen Widerstandes 34 zugeführt, wobei mit abnehmender Steuergleichspannung der Widerstandswert des dynamischen Widerstandes 34 abnimmt. Auf diese Weise wird bei abnehmender Steuergleichspannung das Spannungsteilerverhältnis zwischen dem Serienvorwiderstand 25 und dem durch die beiden Dioden 32 und 33 gebildeten, in seinem Widerstandswert steuerbaren dynamischen Widerstand 34 so verändert, daß ein Absenken des Pegels des dem Signaleingang 19 des CMOS-Inverters 14 zugeführten Tonsignales erreicht wird. Somit wird mit dem dynamischen Widerstand 34 ein zusätzlicher Effekt zum Steuern des Pegels eines Tonsignales erhalten, der sich gleichsinnig den beiden vorstehend genannten Effekten, nämlich der Abnahme der Verstärkung und der Zunahme des dynamischen Ausgangswiderstandes des CMOS-Inverters 14 bei abnehmender Steuergleichspannung, überlagert, wodurch der Einstellbereich bei der elektronischen Steuerung beziehungsweise Einstellung des Pegels eines Tonsignales weiter vergrößert wird. Durch das Vorsehen des dynamischen Widerstandes 34 ist zusätzlich einer Übersteuerung des CMOS-Inverters 14 bei abnehmender Steuergleichspannung, die als Versorgungsspannung für den CMOS-Inverter dessen Versorgungsspannunganschluß zugeführt wird, vorgebeugt. Durch das Vorsehen von zwei solchen in Serie geschalteten Dioden als dynamischer Widerstand ist vorteilhafterweise erreicht, daß der dynamische Widerstand unabhängig von der Signalamplitude des an den Dioden anliegenden Tonsignales im wesentlichen konstant bleibt.

Die Verbindung 31 zwischen dem Serienvorwiderstand 25 und dem Signaleingang 19 des CMOS-Inverters 14 und die Verbindung 35 zwischen den beiden Dioden 32 und 33 des dynamischen Widerstandes 34 sind über einen Kondensator 38 verbunden. Der Kondensator 38 bildet mit dem Serienvorwiderstand 25 einen Hochpaß 39, über den Mittelton- und Hochton-Signalanteile eines in seinem Pegel zu steuernden Tonsignales dem dynamischen Widerstand 34 zur Bedämpfung dieser Signalanteile zugeführt werden. Dabei ist die Grenzfrequenz dieses Hochpasses 39 mit etwa 300Hz gewählt. Bei geringen Lautstärken - die dann vorliegen, wenn die Steuergleichspannung am Ausgang 16 der Spannungseinstellstufe 15 auf niedrige Spannungswerte eingestellt ist, wobei dann der dynamische Widerstand 34 einen kleinen Widerstandswert aufweist - werden über den dynamischen Widerstand 34 aufgrund dessen kleinen Wertes die über den Hochpaß 39 abgeleiteten Mittelton- und Hochton-Signalanteile über den Vorwiderstand 36 zum Versorgungsspannungsanschluß +V und über den Vorwiderstand 37 und den Kondensator 30 zur Masse abgeleitet, wodurch die Mittelton- und Hochton-Signalanteile gegenüber den nicht abgeleiteten Tiefton-Signalanteilen abgesenkt werden. Dies entspricht einer relativen Anhebung der Tiefton-Signalanteile gegenüber den Mittelton- und Hochton-Signalanteilen bei geringen Lautstärken. Bei großen Lautstärken - die dann vorliegen, wenn die Steuergleichspannung am Ausgang 16 der Spannungseinstellstufe 15 auf hohe Spannungswerte eingestellt ist, wobei dann der dynamische Widerstand 34 einen großen Widerstandswert aufweist - efolgt über den dynamischen Widerstand 34 aufgrund dessen großen Wertes praktisch kein Ableiten von Mittelton- und Hochton-Signalanteilen, so daß bei großen Lautstärken keine relative Anhebung der Tiefton- Signalanteile gegenüber den Mittelton- und Hochton-Signalanteilen erfolgt. Auf diese Weise wird eine hinsichtlich von Tiefton-Signalanteilen gute physiologische Lautstärkensteuerung erhalten.

Mit dem vom Signaleingang 19 des CMOS-Inverters 14 abgewandten Anschluß des Serienvorwiderstandes 25, der mit dem Trennkondensator 26 verbunden ist, ist weiters ein Anschluß eines weiteren Hochpasses 40 verbunden, dessen anderer Anschluß mit der Diode 33 des dynamischen Widerstandes 34 an der Kathode der Diode 33 verbunden ist. Der weitere Hochpaß 40 besteht aus einem Kondensator 41 und einem zu diesem in Serie geschalteten Widerstand 42. Die Grenzfrequenz dieses weiteren Hochpasses 40 ist mit etwa 3kHz gewählt. Über den weiteren Hochpaß 40 und die mit diesem verbundene Diode 33 des dynamischen Widerstandes 34 sowie den zwischen der Verbindung 35 zwischen den beiden Dioden 32 und 33 und der Verbindung 31 zwischen dem Serienvorwiderstand 25 und dem Signaleingang 19 des CMOS-Inverters 14 vorgesehenen Kondensator 38 werden unter teilweiser Überbrückung des Serienvorwiderstandes 25 Hochton-Signalanteile eines in seinem Pegel zu steuernden Tonsignales zusätzlich dem Signaleingang 19 des CMOS-Inverters 14 zur Anhebung dieser Hochton-Signalanteile zugeführt. Bei geringen Lautstärken - die dann vorliegen, wenn die Steuergleichspannung am Ausgang 16 der Spannungseinstellstufe 15 auf niedrige Spannungswerte eingestellt ist, wobei dann der dynamische Widerstand 34 einen kleinen Widerstandswert aufweist - werden über den Hochpaß 40, die Diode 33, die dann einen kleinen Widerstandswert aufweist, und den Kondensator 38 dem Signaleingang 19 zusätzlich Hochton-Signalanteile zugeführt, was eine Anhebung dieser Hochton-Signalanteile bei geringen Lautstärken zur Folge hat. Bei großen Lautstärken - die dann vorliegen, wenn die Steuergleichspannung am Ausgang 16 der Spannungseinstellstufe 15 auf hohe Spannungswerte eingestellt ist, wobei dann der dynamische Widerstand 34 einen großen Widerstandswert aufweist - erfolgt aufgrund des großen Widerstandswertes der Diode 33 praktisch keine zusätzliche Zufuhr von Hochton-Signalanteilen zu dem Signaleingang 19 des CMOS-Inverters 14, so daß bei großen Lautstärken keine Anhebung der Hochton-Signalanteile erfolgt. Auf diese Weise wird bei geringen Lautstärken zusätzlich zu der vorstehend erwähnten Anhebung der Tiefton-Signalanteile auch eine Anhebung der Hochton-Signalanteile eines in seinem Pegel zu steuernden Tonsignales erreicht, wodurch eine besonders gute physiologische Lautstärkensteuerung erhalten wird. Es sei erwähnt, daß der weitere Hochpaß 40 auch mit der anderen Diode 32 des dynamischen Widerstandes 34 an der Anode der Diode 32 verbunden sein könnte, was den gleichen vorteilhaften Effekt ergäbe. Der weitere Hochpaß 40 könnte über je einen weiteren Widerstand auch mit beiden Dioden 32 und 33 des dynamischen Widerstandes 34 an den von der Verbindung 35 zwischen den beiden Dioden 32 und 33 abgewandten Anschlüssen der Dioden verbunden sein, was ebenfalls den gleichen vorteilhaften Effekt ergäbe.

## Patentansprüche

1. Schaltungsanordnung zur elektronischen Pegelsteuerung eines Tonsignales mit einer in einen Tonsignalweg eingeschalteten Verstärkerschaltung (14), deren Verstärkungsgrad in Abhängigkeit von einer veränderbaren Steuergleichspannung steuerbar ist, und mit einer Spannungseinstellstufe (15) zum Erzeugen der veränderbaren Steuergleichspannung, von deren Ausgang (16) die erzeugte veränderbare Steuergleichspannung der Verstärkerschaltung (14) zur Steuerung von deren Verstärkungsgrad zugeführt wird, dadurch gekennzeichnet, daß die Verstärkerschaltung (14) durch einen CMOS-Inverter (14) mit einem Signaleingang (19), einem Signalausgang (20) und einem Versorgungsspannungsanschluß (21) gebildet ist, dessen Signaleingang (19) ein Serienvorwiderstand (25) vorgeschaltet ist, über den das in seinem Pegel zu steuernde Tonsignal dem Signaleingang (19) des CMOS-Inverters (14) zugeführt wird, und von dessen Signalausgang (20) das in seinem Pegel gesteuerte Tonsignal abgenommen wird und dessen Versorgungsspannungsanschluß (21) die mit der Spannungseinstellstufe (15) erzeugte veränderbare Steuergleichspannung als Versorgungsspannung für den CMOS-Inverter (14) zugeführt wird, wobei in Abhängigkeit von der dem Versorgungsspannungsanschluß (21) zugeführten Steuergleichspannung der CMOS-Inverter (14) in seinem Anlaufbereich unterhalb der Kniespannung betrieben wird, in dem mit abnehmender Steuergleichspannung der Verstärkungsgrad des CMOS-Inverters (14) abnimmt und zusätzlich der dynamische Ausgangswiderstand des CMOS-Inverters (14) zunimmt.

2. Schaltungsanordnung nach Anspruch 1, dadurch gekennzeichnet, daß an die Verbindung zwischen dem Serienvorwiderstand (25) und dem Signaleingang (19) des CMOS-Inverters (14) ein im wesentlichen durch zwei in Serie geschaltete Dioden (32, 33) gebildeter, in seinem Widerstandswert steuerbarer dynamischer Widerstand (34) angeschaltet ist, wobei die Verbindung zwischen dem Serienvorwiderstand (25) und dem Signaleingang (19) des CMOS-Inverters (14) mit der Verbindung (35) zwischen den beiden Dioden (32,33) des dynamischen Widerstandes (34) verbunden ist, der mit dem Serienvorwiderstand (25) einen Spannungsteiler für das dem CMOS-Inverter (14) zugeführte, in seinem Pegel zu steuernde Tonsignal bildet, und daß die mit der Spannungseinstellstufe (15) erzeugte veränderbare Steuergleichspannung dem durch die beiden Dioden (32,33) gebildeten dynamischen Widerstand (34) an einem Anschluß einer Diode (33) zur Steuerung des Widerstandswertes desselben zugeführt wird, wobei mit abnehmender Steuergleichspannung der Widerstandswert des durch die beiden Dioden (32,33) gebildeten dynamischen Widerstandes (34) abnimmt.

3. Schaltungsanordnung nach Anspruch 2, dadurch gekennzeichnet, daß die Verbindung zwischen dem Serienvorwiderstand (25) und dem Signaleingang (19) des CMOS-Inverters (14) und die Verbindung (35) zwischen den beiden Dioden (32,33) des dynamischen Widerstandes (34) über einen Kondensator (38) verbunden sind, der mit dem Serienvorwiderstand (25) einen Hochpaß bildet, über den Mittelton- und Hochton-Signalanteile eines in seinem Pegel zu steuernden Tonsignales dem dynamischen Widerstand (34) zur Bedämpfung dieser Signalanteile zugeführt werden.

4. Schaltungsanordnung nach Anspruch 3, dadurch gekennzeichnet, daß mit dem vom Signaleingang (19) des CMOS-Inverters abgewandten Anschluß des Serienvorwiderstandes (25) ein Anschluß eines weiteren Hochpasses (40) verbunden ist, dessen anderer Anschluß mit mindestens einer Diode (33) des dynamischen Widerstandes (34) an dem von der Verbindung (35) zwischen den beiden Dioden (32,33) abgewandten Anschluß der Diode (33) verbunden ist, wobei unter teilweiser Überbrückung des Serienvorwiderstandes (25) über den weiteren Hochpaß (40) und die mit diesem verbundene Diode (33) des dynamischen Widerstandes (34) sowie den zwischen der Verbindung (35) zwischen den beiden Dioden (32,33) und der Verbindung zwischen dem Serienvorwiderstand (25) und dem Signaleingang (19) des CMOS-Inverters (14) vorgesehenen Kondensator (38) Hochton-Signalanteile eines in seinem Pegel zu steuernden Tonsignales zusätzlich dem Signaleingang (19) des CMOS-Inverters (14) zur Anhebung dieser Hochton-Signalanteile zugeführt werden.

## Claims

1. A circuit arrangement for the electronic level control of a sound signal, comprising an amplifier circuit (14) which is included in a sound signal path and whose gain can be controlled in dependence on a variable d.c. control voltage, and a voltage control stage (15) for generating the variable d.c. control voltage, the generated variable d.c. control voltage being applied from the output (16) of this voltage control stage to the amplifier circuit (14) in order to control the gain of this amplifier circuit, characterised in that the amplifier circuit (14) is formed by a CMOS inverter (14) having a signal input (19), a signal output (20) and a supply voltage terminal (21), which signal input (19) is preceded by a series resistor (25) *via* which the sound signal whose level is to be controlled is applied to the signal input (19) of the CMOS inverter (14), on which signal output (20) the level-controlled sound signal is available, and to which supply voltage terminal (21) the variable d.c. control voltage generated by means of the voltage control stage (15) is applied as supply voltage for the CMOS inverter (14), the CMOS inverter (14) being operated, in dependence on the d.c. control voltage applied to the supply voltage terminal (21), below the knee voltage in its starting region, in which the gain of the CMOS inverter (14) decreases and, in addition, the dynamic output resistance of the CMOS inverter (14) increases as the d.c. control voltage decreases.

2. A circuit arrangement as claimed in Claim 1, characterised in that a dynamic resistance, which is essentially formed by two series-connected diodes (32, 33) and whose resistance value is controllable, is coupled to the connection between the series resistor (25) and the signal input (19) of the CMOS inverter (14), the connection between the series resistor (25) and the signal input (19) of the CMOS inverter (14) being connected to the connection (35) between the two diodes (32, 33) of the dynamic resistance (34), which together with the series resistor (25) forms a voltage divider for the sound signal whose level is to be controlled and which is applied to the CMOS inverter (14), and in that the variable d.c. control voltage generated by means of the voltage control stage (15) is applied to a terminal of a diode (33) of the dynamic resistance (34) formed by the two diodes (32, 33) to control the resistance value of this dynamic resistance, the resistance value of the dynamic resistance (34) formed by the two diodes (32, 33) decreasing as the d.c. control voltage decreases.

3. A circuit arrangement as claimed in Claim 2, characterised in that the connection between the series resistor (25) and the signal input (19) of the CMOS inverter (14) and the connection (35) between the two diodes (32, 33) of the dynamic resistance (34) are connected *via* a capacitor (38) which together with the series resistor (25) forms a high-pass filter *via* which mid-range and treble signal components of a sound signal whose level is to be controlled are applied to the dynamic resistance (34) to attenuate these signal components.

4. A circuit arrangement as claimed in Claim 3, characterised in that the series resistor (25) has its terminal which is remote from the signal input (19) of the CMOS inverter connected to a terminal of a further high-pass filter (40) whose other terminal is connected to at least one diode (33) of the dynamic resistance (34), to the terminal of the diode (33) which is remote from the connection (35) between the two diodes (32, 33), treble signal components of a sound signal whose level is to be controlled being additionally applied to the signal input (19) of the CMOS inverter (14), with the series resistor (25) being partly bypassed to boost these treble signal components, *via* the further high-pass filter (40), the diode (33) of the dynamic resistance (34) connected to this further high-pass filter, and the capacitor (38) arranged between the connection (35) between the two diodes (32, 33) and the connection between the series resistor (25) and the signal input (19) of the CMOS inverter (14).

## Revendications

1. Circuit de commande électronique du niveau d'un signal sonore avec un circuit amplificateur (14), mis en circuit dans un chemin de signal sonore et dont le degré d'amplification peut être commandé en fonction d'une tension continue de commande modifiable et avec un étage de réglage de tension (15), destiné à produire la tension continue de commande modifiable, étage de la sortie (16) duquel la tension continue de commande modifiable produite est amenée au circuit amplificateur (14) pour commander son degré d'amplification, caractérisé en ce que le circuit amplificateur (14) est constitué par un inverseur CMOS (14), avec une entrée de signal (19), une sortie de signal (20) et un raccordement de tension d'alimentation (21), une résistance série chutrice (25) étant mise en circuit en amont de son entrée de signal (19), résistance par l'intermédiaire de laquelle le signal sonore, dont le niveau est à commander, est amené à l'entrée de signal (19) de l'inverseur CMOS (14), de la sortie de signal (20) duquel le signal sonore, dont le niveau est commandé, est prélevé et, à partir du raccordement de tension d'alimentation (21) de l'inverseur CMOS (14), la tension continue de commande modifiable, produite à l'aide de l'étage de réglage de tension (15), est amenée, à titre de tension d'alimentation pour l'inverseur CMOS (14), où, en fonction de la tension continue de commande amenée au raccordement de tension d'alimentation (21), l'inverseur CMOS (14) fonctionne dans sa plage de démarrage au-dessous de la tension de saturation de collecteur, par le fait que, lorsque la tension continue de commande diminue, le degré d'amplification de l'inverseur CMOS (14) diminue et que, en plus, la résistance de sortie dynamique de l'inverseur CMOS (14) augmente.

2. Circuit selon la revendication 1, caractérisé en ce que, sur la liaison entre la résistance série chutrice (25) et l'entrée de signal (19) de l'inverseur CMOS (14) est raccordée une résistance dynamique (34) constituée par deux diodes (32, 33) branchées en série et dont la valeur de la résistance peut être commandée, la liaison entre la résistance série chutrice (25) et l'entrée de signal (19) de l'inverseur CMOS (14) étant reliée à la liaison (35) entre les deux diodes (32, 33) de la résistance dynamique (34), la résistance (34) constituant, avec la résistance série chutrice (25), un diviseur de tension pour le signal sonore amené à l'inverseur CMOS (14) et dont on veut commander le niveau, et en ce que la tension continue de commande modifiable, produite à l'aide de l'étage de réglage de tension (15), est amenée, au moyen de la résistance dynamique (34) constitué par les deux diodes (32, 33), à un raccordement d'une diode (33), destiné à commander la valeur de la résistance de celle-ci, où, lorsque la tension continue de commande diminue, la valeur ohmique de la résistance (34) dynamique constituée par les deux diodes (32, 33) diminue.

3. Circuit selon la revendication 2, caractérisé en ce que la liaison entre la résistance série chutrice (25) et l'entrée de signal (19) de l'inverseur CMOS (14) et la liaison (35), entre les deux diodes (32, 33), de la résistance dynamique (34) sont reliées par un condensateur (38), qui constitue, avec la résistance série chutrice (25), un filtre passe-haut, par l'intermédiaire duquel les composantes médianes et supérieures du signal sonore, dont le niveau est à commander, sont amenées à la résistance dynamique (34), en vue d'amortir ces composantes du signal.

4. Circuit selon la revendication 3, caractérisé en ce que, au raccordement, dérivé de l'entrée de signal (19) de l'inverseur CMOS, de la résistance série chutrice (25) est raccordé un autre composant passe-haut (40), dont l'autre raccordement, à au moins une diode (33) de la résistance dynamique (34), est relié au raccordement de diode (33) dérivé de la liaison (35) entre les deux diodes (32, 33), où, en pontant partiellement la résistance série chutrice (25), par l'intermédiaire du composant passe-haut (40) supplémentaire et de la diode (33), reliée à celui-ci, de la résistance dynamique (34), ainsi que par l'intermédiaire du condensateur (38), prévu entre la liaison (35) constituée entre les deux diodes (32, 33) et la liaison constituée entre la résistance série chutrice (25) et l'entrée de signal (19) de l'inverseur CMOS (14), les composantes supérieures du signal sonore, dont le niveau est à commander, sont en plus amenées à l'entrée de signal (19) de l'inverseur CMOS (14), en vue d'éliminer ces composantes supérieures du signal sonore.
